# FASCICULE DE BREVET EUROPEEN

(11) **EP 0 478 476 B1**
(45) Date de publication et mention de la délivrance du brevet: **06.03.1996**
(21) Numéro de dépôt: 91420337.7
(22) Date de dépôt: 24.09.1991
(51) Int. Cl.: H01L 21/56, B29C 45/14

(54) **Procédé de moulage pour boîtiers de circuit intégré et moule**
Gussverfahren für integrierte Schaltungspackungen und Gussform
Moulding process for integrated circuit packages and moulds

(30) Priorité: 27.09.1990 FR 9012211
(43) Date de publication de la demande: 01.04.1992
(73) Titulaire: SGS-THOMSON MICROELECTRONICS S.A., F-94250 Gentilly (FR)
(72) Inventeur: Brechignac, Rémi, F-38360 Sassenage (FR); Lamourelle, François, F-38000 Grenoble (FR)
(74) Mandataire: de Beaumont, Michel

(56) Documents cités:
- EP-A- 0 258 098
- AT-A- 308 386
- PATENT ABSTRACTS OF JAPAN vol. 10, no. 207 (M-500)(2263) 19 Juillet 1986 & JP-A-61 047 228
- PATENT ABSTRACTS OF JAPAN vol. 8, no. 131 (E-251)(1568) 19 Juin 1984 & JP-A-59 043 530

## Description

La présente invention concerne les boîtiers pour circuits intégrés et, en particulier, un nouveau procédé de moulage.

Le moulage d'un boîtier pour cuircuits intégrés consiste, en général, à injecter un produit de protection et d'isolation tel qu'une résine dans un moule contenant une puce connectée à ses broches de connexion. Les broches de connexion qui doivent être exemptes de produit de protection, dépassent à l'extérieur du moule. Il se pose donc le problème d'arrêter le produit de protection, liquide lors de l'injection dans le moule au niveau des espaces entre les broches de connexion.

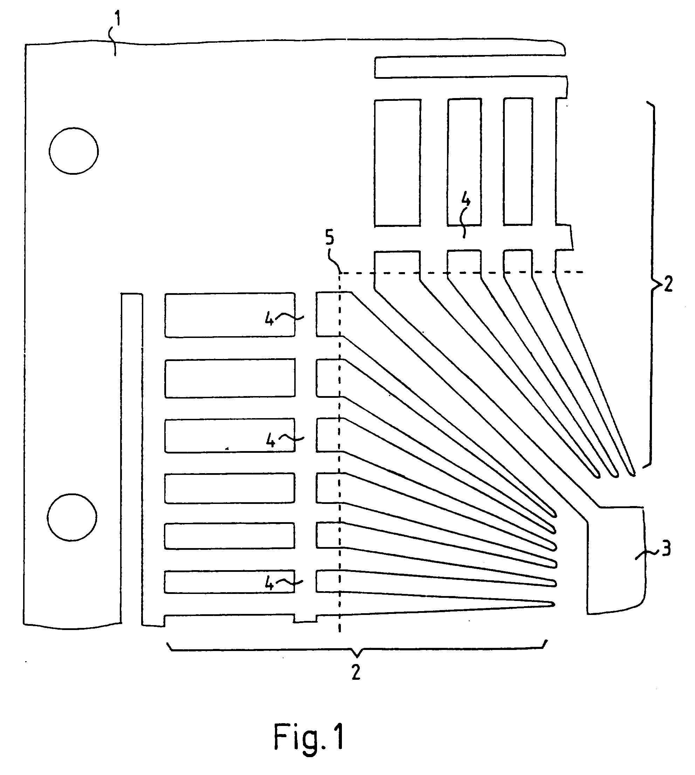

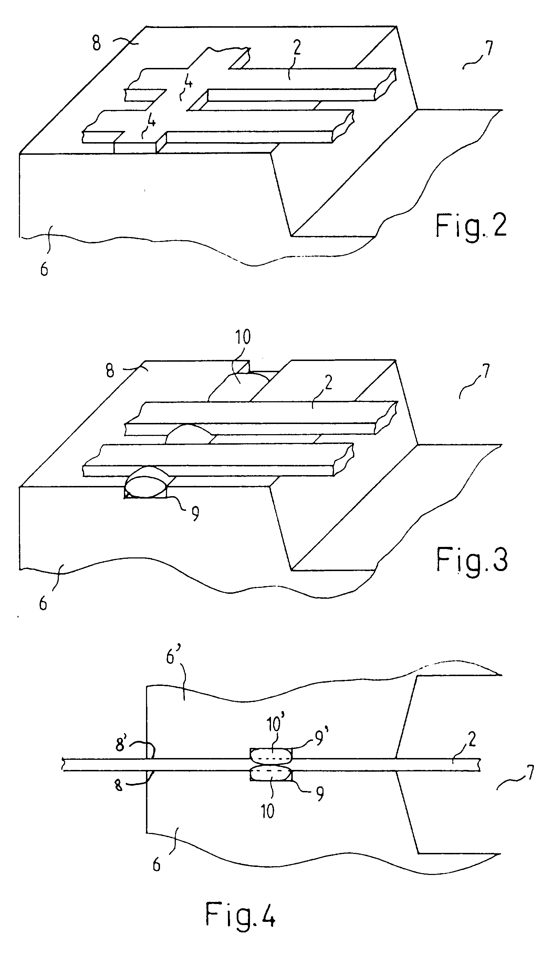

Le procédé le plus répandu à l'heure actuelle pour le montage de circuits intégrés est celui à grille de connexion et liaison par fils. La figure 1 représente une partie d'une grille de connexion 1 qui comporte des broches de connexion 2, une plate-forme 3 pour recevoir la puce et des barres de court-circuit 4, habituellement connues sous le nom de dambars, qui relient entre elles les broches de connexion 2. Les pointillés 5 indiquent la limite du boîtier à obtenir. Ce sont les barres de liaison 4 qui arrêtent l'écoulement du produit de protection entre les broches de connexion. Leur fonction sera mieux comprise à l'aide de la figure 2.

La figure 2 représente une portion d'un demi-moule inférieur 6 comprenant une cavité de moulage 7 et un plan de joint 8. Le demi-moule supérieur, non représenté, est symétrique. Une fois la fixée sur la plate-forme 3 et connectée aux broches 2, la grille de connexion 1 est positionnée sur le plan de joint 8 du demi-moule 6. Ainsi, les barres de court-circuit 4 sont disposées autour de la cavité 7 du demi-moule 6 et barrent le passage au produit de protection le long des plans de joint, entre les broches, quand le moule est fermé. Les barres de court-circuit 4 doivent ensuite être éliminées.

La tendance actuelle est à la fabrication de circuits intégrés de plus en plus petits et comprenant un nombre croissant de broches de connexion. Les espaces inter-broches de connexion, et par conséquent les barres de court-circuit, deviennent donc aussi de plus en plus petites. Il devient très difficile de supprimer ces barres de court-circuit après le moulage et il faut, pour cela, un outillage de plus en plus précis et coûteux.

Le document JP-A-5943450 décrit une méthode pour éviter la formation de longues bavures le long des broches en prévoyant de former, perpendiculairement aux rainures de broches, une rainure d'arrêt de bavures plus profonde que celle-ci, ou se déverse l'excès de résine formant ainsi un bourrelet très épais mais court.

La présente invention permet de supprimer l'étape d'élimination des barres de court-circuit, il en résulte un gain de temps et de coûteux outillages. Pour aboutir à ce résultat, la présente invention prévoit un procédé de moulage pour boîtiers de circuit intégré comprenant les étapes suivantes : prévoir une grille de connexion ; prévoir un moule en deux parties qui viennent s'appuyer selon des plans de joint de part et d'autre de la grille et qui definissent une cavité de moulage ; connecter une puce aux broches de connexion de la grille ; mettre cet ensemble dans le moule ; et injecter un produit de protection et d'isolation ; les broches de connexion de la grille étant indépendantes les unes des autres, de leur extrémité proximale à leur extrémité distale, et un matériau souple d'étanchéité étant disposé tout autour de la cavité de moulage au niveau des plans de joint.

Selon un mode de réalisation de la présente invention, le matériau souple d'étanchéité est disposé sur un des plans de joint dans au moins une rainure.

Selon un mode de réalisation de la présente invention, le matériau souple d'étanchéité est disposé sur les plans de joint dans des rainures en vis à vis.

Selon un mode de réalisation de la présente invention, le matériau souple d'étanchéité est fixé sur la grille de connexion avant l'introduction dans le moule.

Selon un mode de réalisation de la présente invention, le matériau souple d'étanchéité est un joint torique.

La présente invention prévoit aussi un moule pour boîtiers de circuit intégré comprenant un demi-moule supérieur et un demi-moule inférieur définissant une cavité de moulage et ayant chacun un plan de joint, le plan de joint d'un des demi-moules comportant au moins une rainure entourant la cavité de moulage et contenant un matériau souple d'étanchéité.

Selon un mode de réalisation de la présente invention, les plans de joint des demi-moules inférieur et supérieur comportent des rainures en vis à vis.

Selon un mode de réalisation de la présente invention, les rainures sont segmentées.

Ces objets, caractéristiques et avantages ainsi que d'autres de la présente invention seront exposés plus en détail dans la description suivante de modes de réalisation particuliers faite en relation avec les figures parmi lesquelles :
les figures 1 et 2, représentant l'art antérieur, ont été décrites précédemment ;
la figure 3 représente un mode de réalisation d'un moule mettant en oeuvre la présente invention ; et
la figure 4 représente un autre mode de réalisation d'un moule mettant en oeuvre la présente invention.

A la figure 3, on retrouve la même portion de demi-moule inférieur 6 que dans la figure 2 à la différence qu'il comporte, selon l'invention, sur son plan de joint 8 une rainure 9 entourant la cavité de moulage 7. Le demi-moule supérieur, non représenté, ne comporte pas de rainure. Un anneau en matériau souple 10 est disposé dans la rainure 9. Une grille de connexion est positionnée sur le demi-moule 6, les broches de connexion 2 venant s'appuyer sur l'anneau 10. Quand on ferme le moule, l'anneau 10 est écrasé et le matériau souple refoulé vient obstruer les espaces entre broches de connexion. La grille est dépourvue de barres de court-circuit, c'est-à-dire que les broches de connexion sont indépendantes les unes des autres de leur extrémité proximale à leur extrémité distale.

La figure 4 est une vue en coupe partielle de deux demi-moules selon un autre mode de réalisation de la présente invention. Deux demi-moules symétriques 6 et 6′ comportent sur leurs plans de joint 8 et 8′ deux rainures en vis à vis 9 et 9′ entourant la cavité de moulage 7. Deux anneaux en matériau souple 10 et 10′ sont disposés dans les rainures. Lors de la fermeture du moule, les anneaux s'écrasent et le matériau souple refoulé vient obstruer les espaces entre broches de connexion. Cette variante convient particulièrement à des broches de connexion plus épaisses.

Selon un autre mode de réalisation de la présente invention, les plans de joint des demi moules peuvent comporter plusieurs rainures recevant chacune son anneau en matériau souple.

Selon un autre mode de réalisation de la présente invention, les anneaux en matériau souple sont préalablement fixés sur la grille de connexion pour permettre l'utilisation d'un moule classique sans rainures. Cette variante a pour avantage d'augmenter la rigidité de la grille de connexion.

Selon un autre mode de réalisation de la présente invention, au lieu de disposer du matériau souple tout autour de la cavité de moulage, on peut prévoir d'en disposer des segments, par exemple quatre, en laissant aux coins des orifices qui, lors de l'injection du produit de protection, permettent l'évacuation de l'air emprisonné.

Les anneaux ou segments en matériau souple utilisés peuvent, par exemple, être des joints toriques standards.

Ainsi, la présente invention permet la suppression des barres de court-circuit et de la coûteuse et délicate étape de suppression de ces barres. Le procédé s'applique à toutes les technologies utilisant auparavant des barres de court-circuit.

## Revendications

1. Procédé de moulage pour boîtiers de circuit intégré comprenant les étapes suivantes :
- prévoir une grille de connexion (1) ;
- prévoir un moule en deux parties (6, 6') qui viennent s'appuyer selon des plans de joint (8, 8') de part et d'autre de la grille (1) et qui définissent une cavité de moulage (7) ;
- connecter une puce aux broches de connexion (2) de la grille (1) ;
- mettre cet ensemble dans le moule (6, 6') ; et
- injecter un produit de protection et d'isolation ;
caractérisé en ce que les broches de connexion (2) de la grille (1) sont indépendantes les unes des autres, de leur extremité proximale à leur extrémité distale, et en ce qu'un matériau souple d'étanchéité (10) est disposé tout autour de la cavité de moulage (7) au niveau des plans de joint (8, 8').

2. Procédé selon la revendication 1, caractérisé en ce que le matériau souple d'étanchéité (10) est disposé sur un des plans de joint (8) dans au moins une rainure (9).

3. Procédé selon la revendication 1, caracterisé en ce que le matériau souple d'étanchéité (10, 10') est disposé sur les plans de joint (8, 8') dans des rainures en vis à vis (9, 9').

4. Procédé selon la revendication 1, caractérisé en ce que le matériau souple d'étanchéité (10) est fixé sur la grille de connexion (1) avant l'introduction dans le moule (6, 6').

5. Procédé selon l'une quelconque des revendications 1 à 4, caractérisé en ce que le matériau souple d'étanchéite est un joint torique.

6. Moule pour boîtiers de circuit intégré comprenant un demi-moule supérieur (6') et un demi-moule inférieur (6) définissant une cavité de moulage (7) et ayant chacun un plan de joint (8, 8'), caractérisé en ce que le plan de joint (8) d'un des demi-moules (6) comporte au moins une rainure (9) entourant la cavité de moulage (7) et contenant un matériau souple d'étancheité (10).

7. Moule selon la revendication 6, caractérisé en ce que les plans de joint (8, 8′) des demi-moules inférieur et supérieur (6, 6′) comportent des rainures (9, 9′) en vis à vis.

8. Moule selon une quelconque des revendications 6 ou 7, caractérisé en ce que les rainures (9, 9′) sont segmentées.

## Patentansprüche

1. Formverfahren für Gehäuse von integrierten Schaltungen, welches die folgenden Schritte umfaßt:
- Bereitstellen eines Verbindungsrahmens (1),
- Bereitstellen einer Form mit zwei Teilen (6, 6'), welche sich entlang von Formtrennungsflächen (8, 8') zu beiden Seiten des Rahmens (1) aufeinanderdrücken lassen und welche einen Formhohlraum (7) festlegen,
- Verbinden eines Chips mit den Verbindungsstiften (2) des Rahmens (1),
- Einsetzen dieser Anordnung in die Form (6, 6') und
- Injizieren eines Schutz- und Isolationsmittels,
dadurch gekennzeichnet, daß die Verbindungsstifte (2) des Rahmens (1) von ihrem proximalen Ende bis zu ihrem distalen Ende unabhängig voneinander sind und daß ein weiches Dichtmaterial (10) rings um den Formhohlraum (7) auf dem Niveau der Formtrennungsflächen (8, 8') angeordnet ist.

2. Verfahren nach Anspruch 1, dadurch gekennzeichnet, daß das weiche Dichtmaterial (10) in einer der Formtrennungsflächen (8) in zumindest einer Rille (9) angeordnet ist.

3. Verfahren nach Anspruch 1, dadurch gekennzeichnet, daß das weiche Dichtmaterial (10, 10') in den Formtrennungsflächen (8, 8') in einander gegenüberstehenden Rillen (9, 9') angeordnet ist.

4. Verfahren nach Anspruch 1, dadurch gekennzeichnet, daß das weiche Dichtmaterial (10) an dem Verbindungsrahmen (1) vor dem Einsetzen in die Form (6, 6') befestigt wird.

5. Verfahren nach einem der Ansprüche 1 bis 4, dadurch gekennzeichnet, daß das weiche Dichtmaterial ein Dichtring ist.

6. Form für Gehäuse von integrierten Schaltungen, welche einen oberen Formkasten (6') und einen unteren Formkasten (6) umfaßt, die einen Formhohlraum (7) festlegen und jeweils eine Formtrennungsfläche (8, 8') aufweisen, dadurch gekennzeichnet, daß die Formtrennungsfläche (8) eines der Formkästen (6) zumindest eine Rille (9) umfaßt, welche den Formhohlraum (7) umgibt und ein weiches Dichtmaterial (10) enthält.

7. Form nach Anspruch 6, dadurch gekennzeichnet, daß die Formtrennungsflächen (8, 8') des unteren und oberen Formkastens (6, 6') einander gegenüberstehende Rillen (9, 9') umfassen.

8. Form nach einem der Ansprüche 6 oder 7, dadurch gekennzeichnet, daß die Rillen (9, 9') unterteilt sind.

## Claims

1. A method for moulding integrated circuit cases comprising the steps of:
- providing a lead frame (1):
- providing a mould comprised of two half-moulds (6, 6') positioned one with respect to the other according to mould joints (8, 8') on either side of the frame (1) and limiting a moulding cavity (7);
- connecting a chip to the leads (2) of the frame (1);
- placing this assembly in the mould (6, 6'); and
- injecting an encapsulating material;
characterized in that the leads (2) of the frame (1) are independent one from the other from their proximal end and to their distal end, and a soft sealing material (10) is placed around the moulding cavity (7) in the region of the mould joints (8, 8').

2. A method as claimed in claim 1, characterized in that said soft sealing material (10) is placed on one of the mould joints (8) in at least one slot (9).

3. A method as claimed in claim 1, characterized in that said soft sealing material (10, 10') is placed on the mould joints (8, 8') in slots (9, 9') facing each other.

4. A method as claimed in claim 1, characterized in that said soft sealing material (10) is fixed to the lead frame (1) before the introduction in the mould (6, 6').

5. A method as claimed in any of the previous claims, characterized in that said soft sealing material is a seal ring.

6. A mould for integrated circuit cases comprising an upper half-mould (6') and a bottom half-mould (6) limiting a moulding cavity (7) and having each a mould joint (8, 8'), characterized in that the joint plane (8) of at least one of said half-moulds (6) comprises a slot (9) around the moulding cavity (7) and contains a soft sealing material (10).

7. A mould as claimed in claim 6, characterized in that the mould joints (8, 8') of the upper and bottom half-moulds (6, 6') comprise slots (9, 9') facing each other.

8. A mould as claimed in claim 6 or 7, characterized in that the slots (9, 9') are discontinuous.
